(19) **Europäisches Patentamt / European Patent Office / Office européen des brevets**

(11) **EP 2 101 188 B1**

(12) **EUROPEAN PATENT SPECIFICATION**

(45) Date of publication and mention
of the grant of the patent:
**28.04.2010 Bulletin 2010/17**

(51) Int Cl.:
*G01S 5/14* (2006.01)     *H03J 7/00* (2006.01)
*H03L 7/00* (2006.01)     *H04B 1/38* (2006.01)
*H04L 7/00* (2006.01)

(21) Application number: **08152638.6**

(22) Date of filing: **12.03.2008**

(54) **Multiple clock signal generation from a common oscillator**

Mehrfachtaktsignal-Erzeugung aus einem gemeinsamen Oszillator

Génération de signaux d'horloge multiples à partir d'un oscillateur commun

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(43) Date of publication of application:
**16.09.2009 Bulletin 2009/38**

(73) Proprietor: **Research In Motion Limited**
**Waterloo, Ontario N2L 3W8 (CA)**

(72) Inventor: **Yanni, Mamdouh**
**Kitchener Ontario N2P 2T4 (CA)**

(74) Representative: **Patel, Binesh et al**
**Barker Brettell LLP**
**10-12 Priests Bridge**
**London**
**SW15 5JE (GB)**

(56) References cited:
**EP-A- 1 707 978**     **US-A- 6 064 336**
**US-A1- 2001 028 321**

**Description**

<u>FIELD</u>

The present disclosure relates to clock oscillators and, more particularly, to a method and circuit for generating a plurality of clock signals from a common crystal source.

<u>BACKGROUND</u>

Many modern wireless handheld communications devices, whether cellular telephone handsets or personal digital assistants (PDAs) are equipped with ancillary features.

One such feature that is gaining popularity is a GPS receiver whereby the present location of the handset of the PDA may be established to within a precision of a few to a few hundred feet and by which a precise map of the immediate vicinity and/or directions from such present location to a desired destination may be provided.

Such GPS receiver circuits typically make use of a fixed, free running crystal oscillator (XO) or temperature compensated crystal oscillator (TCXO) to generate a local clock to control its operation and to permit synchronization with a plurality of geosynchronous satellites forming part of the Global Positioning System (GPS).

Typically, wireless handheld communications devices also employ a crystal oscillator to clock and control the cellular radio circuitry and to permit communications with a cellular base station.

Accordingly, as board space and component cost of such devices is generally at a premium, it is desirable to provide a novel and improved circuit and method for implementing a plurality of clock circuits from a common crystal oscillator.

It is further desirable to provide a multiple clock circuit that has a reduced component count and broad footprint.

It is still further desirable to provide a multiple clock event from a common crystal oscillator that may be use in a navigation satellite receiver, which is relatively impervious to adjustments to a voltage control input of the oscillator.

European patent application No. EP1707978 held by Abraham and entitled "Method and Apparatus for Adjusting Reference Oscillator Frequency in a Mobile Wireless Device" discloses a method and apparatus for using a conventional oscillator in a cellular telephone transceiver as a source of a reference signal for a GPS receiver. In one embodiment, the method comprises using a voltage-controlled oscillator ("VCXO") within a cellular telephone transceiver to generate a reference frequency signal for the GPS receiver. Circuitry within the telephone transceiver generates a frequency error signal. Both of these signals are coupled to GPS circuitry and used to control a carrier numerically controlled oscillator ("NCO") and a code NCO. The NCOs produce a tuning signal and a timing signal, respectively. The GPS circuitry uses the NCO generated signals to process GPS signals.

United States Patent No. 6,064,336 issued May 16, 2000 to Krasner and entitled "GPS Receiver Using a Communication Link" discloses a precision carrier frequency signal for calibrating a local oscillator of a GPS receiver which is used in acquired GPS signals. The precision carrier frequency signal is used to calibrate the local oscillator such that the output of the local oscillator, which is used to acquire GPS signals, is modified by a reference signal generated from the precision carrier frequency signal. The GPS receiver locks to the position carrier frequency signal and generates a reference signal. In another aspect, satellite almanac data is transmitted to a remote GPS receiver unit from a base station via a communication link. The remote GPS receiver unit uses the satellite almanac data to determine approximate Doppler data for satellites in view of the remote GPS receiver unit.

United States patent Publication No. US2001/002831A1 published October 11, 2001, filed by Krasner and entitled "GPS Receiver Utilizing a Communication Link" discloses methods and apparatuses for deriving an approximately Doppler for a satellite positioning system (SPS) receiver from an approximate location which is obtained from a cellular communications system information source. In one embodiment, an approximate location of the SPS receiver is derived from the information source and this approximation location is used to determine approximate Dopplers to a plurality of SPS satellites at a given time. The approximate Dopplers are then used to reduce processing time in either determining psuedoranges to the SPS satellites or acquiring signals from the SPS satellites. In another aspect, a reference signal is used to provide a local oscillator signal which is used to acquire SPS signals in an SPS receiver. This reference signal is extracted from the data signal modulated on a carrier frequency. The data signal on the carrier frequency is transmitted from, in one example, a wireless cell site which is communicating with the SPS receiver which has a cellular base communication receiver.

<u>BRIEF DESCRIPTION OF THE DRAWINGS</u>

The embodiments of the present disclosure will now be described by reference to the following figures, in which identical reference numerals in different figures indicate identical elements and in which:

**Figure 1** is a graphical representation of a front view of an example of a mobile communications device to which example embodiments may be applied;

**Figure 2** is a simplified block diagram of the example device of **Figure 1;**

**Figure 3** is a simplified block diagram of a communications environment suitable for the example device of **Figure 1;**

**Figure 4** is a simplified example block diagram of the WAN communications subsystem and the GPS receiver subsystem for the example device of **Figure 1;**

**Figure** 5 is a simplified block diagram of a numerically controlled oscillator suitable for use in the example block diagram of **Figure 4;**

## DETAILED DESCRIPTION

The present disclosure accomplishes the foregoing by providing an additional numerically controlled oscillator (NCO) in the GPS circuitry to clock the GPS circuitry from a voltage controlled temperature compensated crystal oscillator (VCTCXO) that is present in the handheld device to provide a clock signal for the cellular communications circuitry. The NCO may generate any of a number of multiple output frequencies from a single input frequency provided by the VCTCXO, in a phase continuous fashion.

By monitoring frequency PPM (parts per million) clock error hits of the cellular communications circuitry, the value of a phase increment register of the NCO may be positively or negatively adjusted to compensate therefor and to ensure a relatively constant phase continuous output frequency for use by the GPS circuitry.

Conventional GPS circuits currently make use of a plurality of NCOs so that the addition of another, which amounts to a passive device comprising a few gates and an adder, will not add significantly to the cost of such devices or occupy a significant amount of board space, especially in comparison to the conventional free-running clock circuit with associated crystal that it effectively replaces. Furthermore, overall power consumption and start-up latency would be reduced and the task of routing clocking signals around the board to minimize interference would be considerably simplified.

Preferably, the additional NCO would be implemented within the GPS circuitry and adapted to be connected to and driven by the existing VCTCXO of the cellular circuitry of the wireless handheld device.

According to a first broad aspect of an embodiment of the present disclosure, there is disclosed a system for providing a clock signal to a navigation satellite receiver (266) in a device (100) comprising a heterodyning communications receiver (221,222), the system comprising: a voltage controlled oscillator (400) for generating an output clock signal (401) having a frequency suitable to heterodyne signals at the heterodyning communications receiver (221,222); and a numerically controlled oscillator (NCO) (490) for generating, from the output clock signal (401), an adjusted output clock signal (491) having a frequency suitable to heterodyne signals at the navigation satellite receiver (266), wherein a frequency of the output clock signal (401) is governed by a voltage signal (464) to the voltage controlled oscillator (400) received from the heterodyning communications receiver (221,222), the frequency of the adjusted output clock signal (491) being adjustable in a phase and frequency continuous manner so as to compensate for a change in an operating environment of the heterodyning communications receiver (221,222).

According to a second broad aspect of an embodiment of the present disclosure, there is disclosed a method for providing a clock signal to a navigation satellite receiver (266) in a device (100) comprising a heterodyning communications receiver (221,222) and a voltage controlled oscillator (400), the method comprising: a. the voltage controlled oscillator (400) generating an output clock signal (401) having a frequency suitable to heterodyne signals at the heterodyning communication receiver (221, 222) and based on a voltage signal (464) received from the heterodyning communications receiver (221,222); and b. a numerically controlled oscillator (NCO) (490) generating, from the output clock signal (401), an adjusted output clock signal (491) in a phase and frequency continuous manner having a frequency suitable to heterodyne signals at the navigation satellite receiver (266), so as to compensate for a change in an operating environment of the heterodyning communications receiver (221,222).

The present disclosure will now be described for the purposes of illustration only, in conjunction with certain embodiments shown in the enclosed drawings.

## The Communications Device

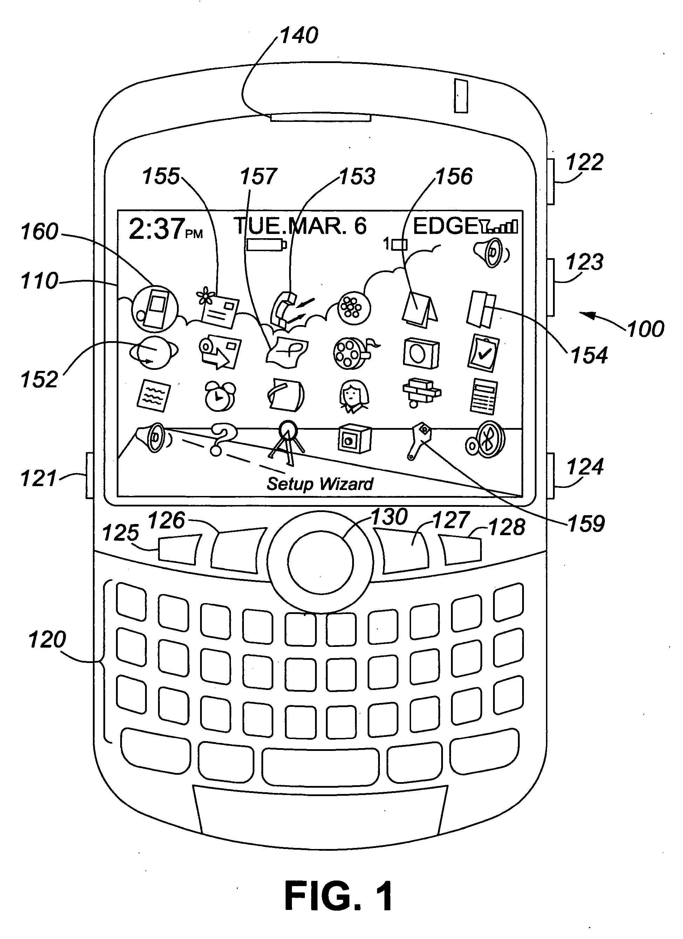

Referring now to the drawings, Figure 1 is a graphical representation of a front view of an example of an electronic communications device 100 to which example embodiments described herein can be applied. The communications device 100 is a two-way mobile communications device having electronic messaging communications capabilities and possibly also voice communications capabilities. Depending on the functionality provided by the communications device 100, in various embodiments the communications device 100 may be a data communications device, a multiple-mode communications device configured for both data and voice communication, a mobile telephone, a PDA enabled for wireless communications, a computer system with a wireless modem or wireless network card, or a computer or phone device with a fixed connection to a network, among other things. The communications device 100 is, in at least one example embodiment, a handheld device having a casing or housing that is dimensioned to fit into a purse, pocket or belt-mounted device holster.

The communications device **100** includes a display screen **110,** an alphanumeric keyboard or keypad **120,** optionally one or more non-keyboard inputs, such as buttons **121-128** and/or a rotatable input device such as a trackball **130** or scrollwheel (not shown) and a speaker **140.** In some example embodiments keys in the keyboard **120** may contain one or more letters aligned in a QWERTY layout. In some embodiments the keys in the keyboard **120** may not be actual physical keys but may be virtual keys displayed on a touch screen display. In some example embodiments, the keyboard **120** includes a QWERTZ layout, an AZERTY layout, a Dvorak layout, or the like. In some example embodiments, the keyboard- **120** layout has reduced keys, such as a reduced QWERTY layout.

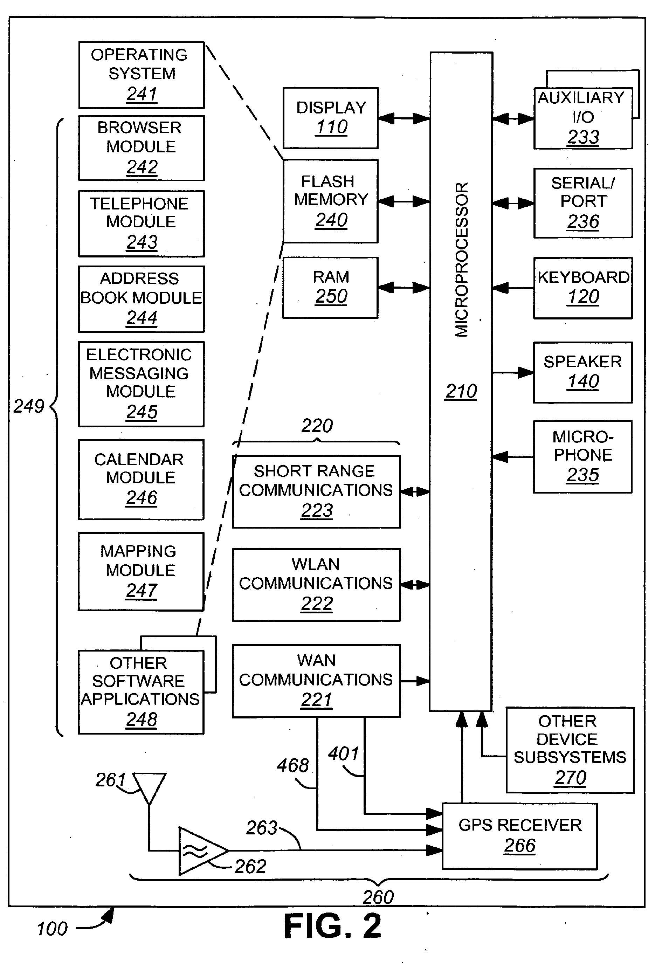

Referring now to **Figure 2,** the communications device **100** includes a controller that includes at least one microprocessor **210** for controlling the overall operation of the device **100.** The microprocessor **210** interacts with a communications subsystem shown generally at **220** and with further device subsystems such as display **110,** keyboard or keypad **120,** one or more auxiliary input / output (I/O) subsystems or devices **233** (e.g. trackball **130,** non-keyboard inputs **121-128** or a scrollwheel (not shown)), a speaker **140,** a microphone **235,** a serial port **236,** a flash memory **240,** random access memory (RAM) **250,** a global positioning system (GPS) receiver subsystem **260,** and any other device subsystems generally designated as **270.**

The microprocessor **210** operates under stored program control of the operating system software and/or firmware **241** and various software and/or firmware applications **249** used by the microprocessor **210,** which are, in one example embodiment, stored in a persistent store such as flash memory **240** or similar storage element. Those skilled in the art will appreciate that the operating system **241,** software applications shown generally at **249,** or parts thereof, may be temporarily loaded into a volatile store such as RAM **250.**

The microprocessor **210,** in addition to its operating system functions, in example embodiments, enables execution of software applications **249** for interacting with the various device subsystems of the device **100.** A predetermined set of software applications **249,** which control basic device operations, including data and voice communication applications, such as a browser module **242,** a telephone module **243,** an address book module **244,** an electronic messaging module **245** (which may include e-mail, SMS messaging and/or PIN messaging) and a calendar module **246,** for example, will normally be installed on the communications device **100** during manufacture. Further software applications **249,** such as a GPS / mapping module **247,** may also be loaded onto the communications device **100** during manufacture, or through the communications subsystem **220,** the auxiliary I/O subsystem **233,** serial port **236,** or any other suitable subsystem **270,** and installed in the RAM **250** or a non-volatile store such as the flash memory **240** for execution by the microprocessor **210.** Such flexibility in application installation increases the functionality of the device **100** and may provide enhanced on-device functions, communication-related functions, or both. In some embodiments, some or part of the functionality of the functional modules can be implemented through firmware or hardware components instead of, or in combination with, computer software instructions executed by the microprocessor **210** (or other processors).

Under instructions from various software applications **249** resident on the communications device **100,** the microprocessor **210** is configured to implement various functional components or modules, for interacting with the various devices subsystems of the device **100.**

The web browser module **242** permits access to a specified web address, for example via data transfer over one or more of the communications subsystem 220 components.

The telephone module **243** enables the communications device 100 to transmit and receive voice and/or data over one or more of the communications subsystem **220** components.

The address book module **244** enables address book information, such as telephone numbers, email and/or instant text messaging addresses and/or PIN numbers to be stored and accessed on the communications device **100.**

The electronic messaging module **245** enables the communications device 100 to send and receive electronic messages over one or more of the communications subsystems **220** components. Examples of electronic messaging include email, personal identification number (PIN) messaging and/or short message service (SMS) messaging.

The calendar module **246** enables appointment and/or task information to be stored and accessed on the communications device **100.**

The GPS / mapping module **247** enables storage, access and/or retrieval of detailed mapping information on the communications device **100** and may provide turn-by-turn directions from an initial map position to a desired destination map position in accordance therewith.

Referring briefly to **Figure 1** again, there is shown an example of handheld communications device **100** on which a plurality of user selectable icons are shown on its display screen **110.** The icons are each associated with functions that can be performed by the communications device **100.** For example, **Figure 1** shows a browser icon **152** for accessing web browsing functions (associated with browser module **242**), a phone icon **153** for accessing phone functionality (associated with telephone module **243),** an address book icon **154** for accessing address book functions (associated with address book module **242**), a messages icon **155** for accessing electronic messaging functions of the communications device **100** (associated with electronic messaging module **245**), a calendar icon **156** for accessing calendar functions (associated with calendar module **246**), a maps icon **157** for accessing GPS / mapping functions (associated with GPS /mapping module **247**), and an options icon **159** (associated with an options module, which may be a separate module or executed by one or more existing modules). An icon is shown highlighted or focused by a caret or selection symbol **160** which can be navigated by a device user among the displayed icons through manipulation of the trackball **130** (or other navigational input device). The trackball **130** is also depressible, such that depression of the trackball **130** when an icon is highlighted or focused by selection symbol **160** results in the launch of functions of the associated module.

In **Figure 2,** each of the software applications **249** may include layout information defining the placement of particular fields, such as text fields, input fields, etc., in a user interface for the software application **249.**

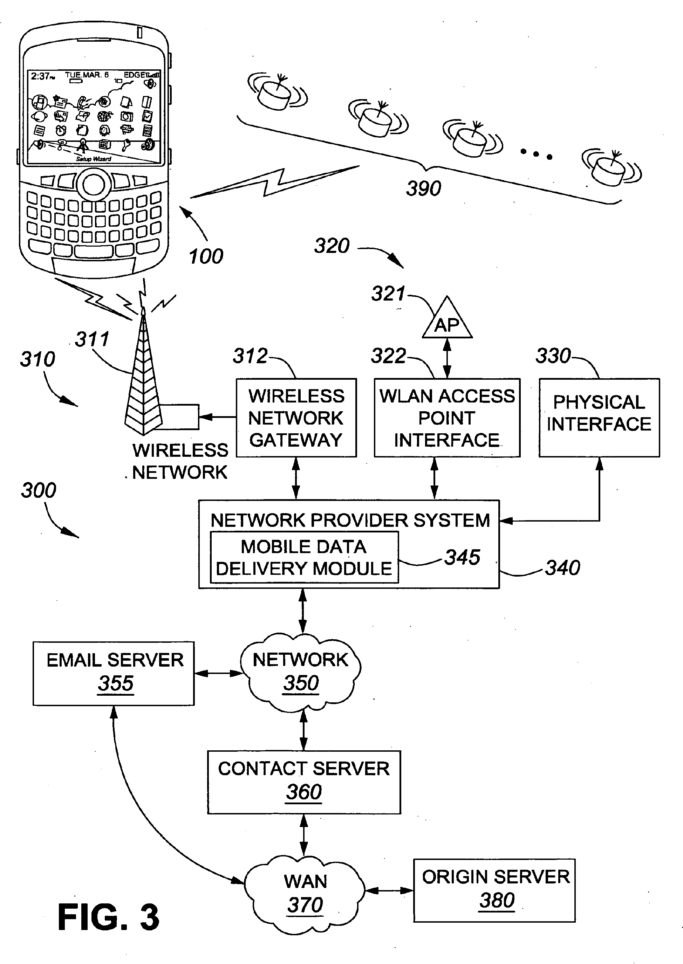

The communications subsystem **220** acts as an interface between the communications device **100** and a communications environment **300** shown in **Figure 3.** As will be apparent to those skilled in the field of communications, the particular configuration of the communications subsystem **220** will be dependent upon the communications network (s) in the communications environment **300** in which the communications device **100** is intended to operate.

In **Figure 3,** the communications environment **300** is shown to include one or more mobile electronic devices **100** (only one of which is shown in **Figure 3**), a wireless Wide Area Network (WAN) **310** and associated base station **311,** a Wireless Local Area Network (WLAN) **320,** and/or other interfaces. In some example embodiments, the communications device **100** is configured to communicate in both data and voice modes over both WAN and WLAN networks and to roam between such networks.

Thus, in the example embodiment shown in **Figure 2,** the communications subsystem **220** includes a WAN communications module **221,** a WLAN communications module **222** and a short range communications module **223.**

The WAN communications module **221** is for two-way communications with the WAN **310** and the WLAN communications module **222** is for two-way communications with the WLAN **320** along an access point **321** associated therewith. Both the WAN communications module **221** and the WLAN communications module **222** operate at radio frequency (RF). For example, if the WAN communications module **221** complies with the Global System for Mobile Communications (GSM) wireless standard, it operates at one or more of 850 MHz, 900 MHz, 1800 MHz or 1900 MHz.

Accordingly, typically, they each comprise front ends having RF antennas, amplifiers, RF transceivers and some signal processing capabilities, implemented, for example, by a digital signal processor.

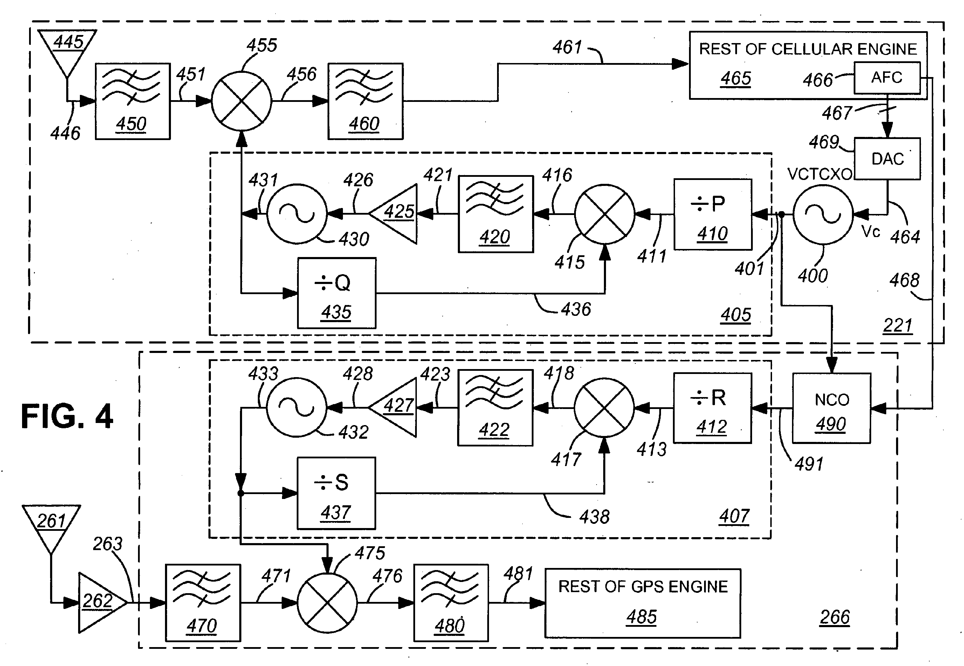

Salient portions of an example embodiment of the front end of a receive path of the WAN communications module **221** (shown in dashed outline) are shown in **Figure 4,** including a voltage controlled TCXO (VCTCXO) **400,** a phase locked loop (PLL) or synthesizer or frequency multiplier circuit **405** (shown in dashed outline), an RF antenna **445,** a first bandpass filter **450,** a WAN RF mixer **455** and a second bandpass filter **465.** The remainder of the cellular engine of the WAN communications module **221** is shown as block **465** and comprises an automatic frequency control module **466.**

The VCTCXO **400** typically comprises a crystal oscillator circuit connected to a crystal (not shown). The crystal generates piezoelectric impulses that are forwarded to the crystal oscillator circuit. The oscillator circuit makes use of high-Q resonance of the piezoelectric effect from the crystal and generates a periodic signal that is typically free-running around a specific nominal frequency, which may be, in an example GSM embodiment, 26 MHz, that it forwards to the PLL **405** along signal line **401.** Due to factors such as temperature, voltage, loading, aging and manufacturing variations, the actual frequency is not typically exactly equal to the nominal frequency. Thus, compensation components (not shown) are added to enhance the temperature stability of the basic oscillator to improve performance.

The crystal is typically one of the more expensive components of the cellular engine, costing on the order of $1.50-$2.00 each.

The PLL **405** may itself comprise, in an example embodiment, a divide by P block **410,** a phase detector **415,** a low pass filter **420,** an amplifier **425,** a voltage controlled oscillator **430** and a divide by Q block **435.**

The divide by P block **410** divides the nominal frequency of the input oscillator signal generated by the VCTCXO **400** and received along signal line **401** down by an integer value P and forwards it to the phase detector **415** along signal line **411.**

The phase detector **415** generates a difference signal between the divided down oscillator reference signal along signal line **411** and a feedback signal **436** generated by the divide by Q block **435.** The difference signal is forwarded to the low pass filter **420** along signal line **416.**

The low pass filter **420** acts as a loop filter and removes any high frequency noise artifacts from the difference signal arriving along signal line **416** and forwards it to the amplifier **425** along signal line **421.**

The amplifier **425** amplifies the filtered difference signal arriving along signal line **421** and forwards it to the VCO **430** as a voltage control signal along signal line **426**. The amount of amplification is chosen to derive an appropriate output frequency for the VCO **430**.

The VCO **430** generates a clock signal that it forwards along signal line **431** to the WAN mixer **455** and the divide by Q block **435** in response to the input therein of the suitably amplified and filtered difference signal arriving along signal line **426**. Advantageously, the clock signal frequency may be appropriate to heterodyne WAN signals down to baseband or IF for processing by the rest of the cellular engine **465**.

The divide by Q block **435** provides a feedback path for the clock signal arriving along signal line **431**. It divides the frequency of the signal by an integer value Q, which generally corresponds to the amount of frequency multiplication effected by the amplification of the voltage control signal **426** from the amplifier **425** before being input to the VCO **430**, and forwards it to a second input of the phase detector **415** along signal line **436**.

The remainder of the front end circuitry of the receiver portion of the WAN communications module **221** is largely conventional. The RF antenna **445** receives and transmits RF signals and forwards the received signals along signal line **446** to the first bandpass filter **450**.

The first bandpass filter **450** filters out of band signals from the received signal arriving along signal line **446** and forwards them to the WAN mixer **455** along signal line **451**.

The WAN mixer **455** heterodynes the filtered received signal arriving along signal line **451** with the clock signal arriving along signal line **431**. The clock signal has a frequency chosen to bring the data content of the filtered received signal down to baseband or to an intermediate frequency. The baseband or IF signal is forwarded to the second bandpass filter **460** along signal line **456**.

The second bandpass filter **460** further filters the baseband or IF signal (to eradicate any undesirable sidelobes arising from the heterodyning operation) and forwards the resulting signal to the rest of the cellular engine (denoted **465**) of WAN communications module **221** along signal line **461** for processing in conventional fashion.

The rest of the cellular engine **465** is also largely conventional. In the present application, it contains an automatic frequency control (AFC) module **466**. The AFC module **466** acts as a frequency lock loop system that is clocked at twice the speed of the basic cellular clock tick. In an example GSM embodiment, the basic tick will be 4.6 ms. The AFC module **466** keeps track of the reference base station frequency timing and implements any appropriate frequency corrections through adjusting the voltage control signal output by the DAC **469** that drives the VCTCXO **400**.

Each time a transmission takes place, a frequency error between the VCTCXO **400** and the reference frequency of the base station is estimated by the AFC module **466**, along with a quality factor. The frequency error is integrated and compared against a threshold dead zone, which may be, in a GSM environment, $\pm 25$ Hz. If the integrated frequency error exceeds the threshold dead zone, a correction is applied to the VCTCXO. Typically, corrections will be made between a minimum (say 10) and a maximum (say 1000) number of frequency error samples.

The number of frequency error samples per frame depends upon the communications scheme and the type of frame. For example, in the GSM system, which contains 8 time slots, a phone call frame will only generate a single frequency error measurement together with its quality metric per frame transmission. On the other hand, in a packet data mode, up to 4 frequency error measurements together with their corresponding quality metrics will be conducted per frame transmission.

Theoretically, once signal lock has been achieved, the frequency and phase of the two signals should closely approximate one another.

With good weather, short sightlines and a stationary device **100**, it is likely that any frequency and/or phase differences between the signal will be minimal. However, when such optimal conditions are not all present, especially when the device **100** is moving quickly, the frequency and phase correspondence between the signals may degrade significantly and rapidly. The problem may be particularly acute when the device **100** is handed over from one base station **311** to another. While the base stations are supposed to be synchronized in frequency, it has been observed in GSM base stations that a frequency disparity of as much to 100 Hz may be present between adjacent base stations **311**. In such circumstances, for example, when the degradation exceeds a predetermined threshold, the AFC module **466** may provide a digital word as a "kick" along signal line **467** to a digital to analog converter (DAC) **469** that is converted into a voltage signal **464**. The voltage signal **464** is fed to the voltage control input of the VCTCXO **400**.

The AFC module **466** also generates a digital word along signal line **468** as a counter-"kick" to a numerically controlled oscillator (NCO) **490** that replaces a clock oscillator circuit for clocking the GPS receiver **266**.

Typically, the AFC module **466** will operate a plurality of AFC frequency lock loops. In addition to the loop described above to maintain frequency synchronization between the device **100** and the currently associated base station **311**, there may be an additional loop to maintain frequency synchronization between the device **100** and a neighbouring base station (not shown) against the possibility of a handover of the device **100** between base stations. In this manner, an appropriate "kick" may be applied at time of handover to compensate for frequency handover error. Anecdotal tests in a local market suggest that the frequency handover error between a pair of GSM base stations is less than about 4 kHz, which can be handled by the described implementation.

Referring back to **Figure 2,** the short-range communications subsystem **223** may provide for communication between the communications device **100** and different systems or devices, which need not necessarily be similar devices. For example, the short-range communications module **223** may include an infrared device and associated circuits and components and/or a Bluetooth™ communications module to provide for communication with similarly enabled systems and devices.

In a data communications mode, a received signal such as a text message or web page download will be processed by the communications subsystem **220** and output to the microprocessor **210,** which further processes the received signal for output to the display **231,** or alternatively to an auxiliary I/O device **233.**

The keyboard **120** and other various input devices, including, an auxiliary I/O device **223** (such as the buttons **121-128** and the trackball **130**) and/or the microphone **235** on the communications device **100** may also be used to compose data items within the software applications **249,** such as email messages or voice communications, in conjunction with the display **110,** possibly an auxiliary I/O device and/or the speaker **140.** Such composed items and/or voice communications may then be transmitted and received over a communications network in the communications environment **300** through the communications subsystem **220.**

The serial port **236** comprises a USB-type interface port for interfacing or synchronizing with another device, such as a desktop computer (not shown). The serial port **236** is used to set preferences through an external device or software application. The serial port **236** may also be used to extend the capabilities of the communications device **100** by providing for information or software downloads, including user interface information, to the communications device **100.**

The flash memory **240** or other persistent storage of the communications device **100** may house, in addition to software and/or firmware stored program instructions, certain information including address book information such as telephone numbers, email and/or instant text messaging addresses and PIN numbers. Such information may also be at least partially stored at least some of the time in memory of a Subscriber Identity Module (SIM) card (not shown) used with the communications device **100,** in volatile device memory (such as the RAM **250**), and/or at a location accessible to the communications device **100** over the WAN **310.**

Additionally, the flash memory **240** may be used to store data structures, preferences and/or parameters.

The RAM **250,** which may constitute non-volatile or volatile memory, with or without battery backup, may be used as a supplement to, or in place of, flash memory **240,** and to maintain data and/or program instructions for use by the microprocessor **210** in executing one or more of the functions of operating system **241** and/or the software applications **249,** including but not limited to the GPS /mapping module **247.**

The GPS receiver subsystem **260** may comprise an antenna **261,** an amplifier **262** and a GPS receiver **266.** Those having ordinary skill in this art will readily appreciate that while the American Global Positioning System (GPS) is referenced throughout, methods and apparatus described in this application may equally be used in conjunction with other types of global or regional navigation satellite systems, including but not limited to the European Galileo, Russian GLONASS, and Chinese Beidou Compass systems.

The antenna **261** is a passive receive-only antenna and is connected to the amplifier **262.**

The amplifier **262,** which may be a low noise amplifier (LNA), is connected to the antenna **261** and to the GPS receiver **266.** It amplifies high-frequency low power signals received from the GPS satellites **390** as discussed below, amplifies them and forwards them to the GPS receiver **266** along signal line **263.**

The GPS receiver **266** is a modified GPS or A-GPS receiver navigation platform, such as the GSC3 LTi GPS chip manufactured by SiRF Technology, Inc.

salient portions of an example embodiment of the front end of the GPS receiver **266** are also shown in **Figure 4,** including NCO **490,** a phase locked loop **407,** a first bandpass filter **470,** a GPS mixer **475** and a second bandpass filter **480.** The remainder of the GPS receiver **266** is shown as block **485.**

The NCO **490** accepts as input the free-running periodic signal along signal line **401** from the VCTCXO **400,** as well as a counter-"kick" digital word along signal line **468** from the AFC module **465.**

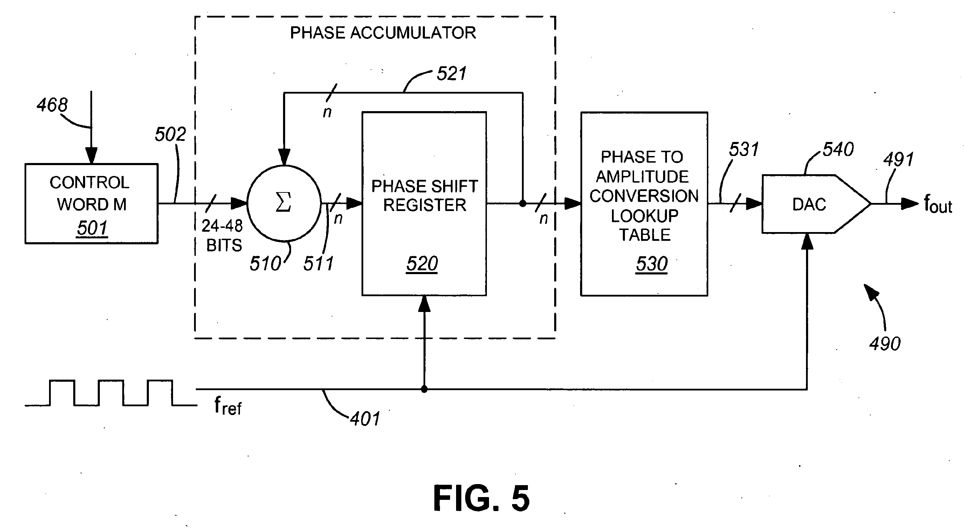

An NCO **490** is a passive device that is able to generate a frequency- and phase-tunable output signal from a fixed-frequency precision clock source. As shown in the representative simplified block diagram of an NCO **490** in **Figure 5,** the NCO **490** comprises an adder **510,** a shift register **520,** a lookup table **530** and a DAC **540.**

The adder **510** accepts two signal lines as inputs. The first signal line **502** is a data bus of typically between 24 and 48 bits emanating from a control or tuning word register **501.** The second signal line **521** is a data bus of length n of typically between 14 and 16 bits emanating from an output of the shift register **520.** The adder **510** successively increments the output of the shift register **520** with the value of the control word ($M$) **501.**

The control word M **501** may be selectively amended by the AFC module **466** by submission of a different value along signal line **468.**

The shift register **520** accepts as input an n-bit data bus **511** from the output of the adder **510** and shifts it out to its output signal line **521,** which is a data bus of length $n$, in response to an input clock signal of frequency $f_{ref}$ **401.** Collectively, the adder **510** and the shift register **520** act as a phase accumulator that increments the stored number each time it receives a clock pulse. The stored number represents a phase of an output clock signal. Thus, the value of the control word $M$ **501** will determine the phase step size of the output clock signal, with a higher frequency being associated with a larger control word value. Thus, the control word M defines the frequency tuning resolution of the NCO **490.**

The lookup table **530** acts as a phase to amplitude converter and outputs a digital word along data bus signal line **531** representative of the amplitude of the output clock signal associated with a given phase value as represented by the output signal **521.**

The DAC **540** converts the digital word input to it along data bus signal line **531** into an analog voltage level that constitutes the output clock signal that it outputs along clock signal **491.**

The relationship between the output frequency $f_{out}$ and the reference clock frequency $f_{ref}$ is set out as follows:

$$f_{out} = \frac{M}{2n} * f_{ref} \qquad\qquad (1)$$

where M is the value of the tuning word **501;**

$f_{ref}$ is the frequency of the input clock signal **522;** and

n is the number of bits in data bus **521.**

The value of the control word $M$ **501** may be adjusted at any time to vary the frequency of the output oscillator signal **491.** The design of the NCO **490** ensures that such frequency changes are phase continuous.

Referring back to **Figure 4,** the NCO **490** alters the frequency output by the VCTCXO **400,** which is suitable to clock the WAN communications subsystem **221,** along signal line **401** to a frequency suitable to clock the GPS receiver **266** and outputs it along signal line **491.**

The PLL **407** may itself comprise, in an example embodiment, a divide by R block **412,** a phase detector **417,** a low pass filter **422,** an amplifier **427,** a voltage controlled oscillator (VCO) **432** and a divide by S block **437.**

The divide by R block **412** divides the nominal frequency of the input oscillator signal generated by the NCO **490** and received along signal line **491** down by an integer value R and forwards it to the phase detector **417** along signal line **413.**

The phase detector **417** generates a difference signal between the divided down oscillator reference signal along signal line **413** and a feedback signal **438** generated by the divide by S block **437.** The difference signal is forwarded to the low pass filter **422** along signal line **418.**

The low pass filter **422** acts as a loop filter and removes any high frequency noise artifacts from the difference signal arriving along signal line **418** and forwards it to the amplifier **427** along signal line **423.**

The amplifier **427** amplifies the filtered difference signal arriving along signal line **423** and forwards it to the VCO **432** as a voltage control signal along signal line **428.** The amount of amplification is chosen to derive an appropriate output frequency for the VCO **432.**

The VCO **432** generates a clock signal that it forwards along signal line **433** to the GPS mixer **475** and the divide by S block **437** in response to the input therein of the suitably amplified and filtered difference signal arriving along signal line **426.** Advantageously, the clock signal frequency may be appropriate to heterodyne GPS signals down to baseband or IF for processing by the rest of the GPS engine **485.**

The divide by S block **437** provides a feedback path for the clock signal arriving along signal line **433.** It divides the frequency of the signal by an integer value S, which generally corresponds to the amount of frequency multiplication effected by the amplification of the voltage control signal **428** by the amplifier **427** before being input to the VCO **432,** and forwards it to a second input of the phase detector **417** along signal line **438.**

The remainder of the front end circuitry of the receiver portion of the GPS receiver **266** is largely conventional. The GPS antenna **261** receives RF signals which may be optionally amplified by amplifier **262** and forwards the received signals to the first bandpass filter **450** along signal line **263.**

The first bandpass filter **470** filters out of band signals from the GPS signals arriving along signal line **263** and forwards them to the GPS mixer **475** along signal line **263.**

The GPS mixer **475** heterodynes the filtered received signal arriving along signal line **471** with the clock signal arriving along signal line **433.** The clock signal has a frequency chosen to bring the data content of the filtered received GPS signal down to baseband or to an intermediate frequency. The baseband or IF signal is forwarded to the second bandpass filter **480** along signal line **476.**

The second bandpass filter **480** further filters the baseband or IF signal (to eradicate undesirable sidelobes arising from the heterodyning operation) and forwards the resulting signal to the rest of the GPS engine **485** of GPS receiver **266** along signal line **481** for processing in conventional fashion.

The rest of the GPS engine **485** is entirely conventional. Typically, it contains circuitry to determine an appropriate frequency offset to be applied to the GPS clock signal **476,** by which satellite message transmissions from the navigation satellites **390** may be received and a location of the GPS receiver **266** may be accurately determined.

**The Communications Environment**

Turning now to **Figure 3,** the WAN **310** may be implemented as a packet-based cellular network that includes a number of base stations **311** (only one of which is shown), where each of the base stations **311** provides wireless Radio Frequency (RF) coverage to a corresponding area or cell. The wireless WAN **310** is typically operated by a cellular network service provider that sells subscription packages to users of mobile electronic devices. The WAN **310** comprises a number of different types of networks, for example, Mobitex Radio Network, DataTAC, GSM, GPRS (General Packet Radio System), TDMA (Time Division Multiple Access), CDMA (Code Division Multiple Access), CDPD (Cellular Digital Packet Data), IDEN (Integrated Digital Enhanced Network) or various other third generation networks such as EDGE (Enhanced Data rates for GSM Evolution) or UMTS (Universal Mobile Telecommunications Systems).

The communications environment **300** also includes a wireless network gateway **312** and one or more network provider systems **340.** The wireless network gateway **312** provides translation and routing services between the network provider system(s) **340** and the WAN **310,** which facilitates communication between the mobile electronic devices **100** and other devices (not shown) connected, directly or indirectly, to the network provider system **340.**

The WLAN **320** comprises a network which, in some example embodiments conforms to IEEE 802.11 standards such as 802.11b and/or 802.11g; however, other communications protocols may also be used for the WLAN **320.** The WLAN **320** includes one or more wireless RF Access Points (AP) **321** (one of which is shown), that collectively provide a WLAN coverage area. The WLAN **320** may be operated by an enterprise (for example, a business or university) and the access points **321** are connected to an access point (AP) interface **322.** The AP interface **322** provides translation and routing services between the access points **321** and the network provider system **340** to facilitate communication between the mobile electronic device **100** and other devices (not shown) connected directly or indirectly, to the network provider system **340.** The AP interface **322** is implemented using a computer, for example, a server running a suitable computer program or software.

According to one embodiment, other interfaces may be implemented using a physical interface **330.** The physical interface **330** may include an Ethernet, Universal Serial Bus (USB), Firewire and/or infrared (IR) connection implemented to exchange information between the network provider system **340** and the communications device **100** when physically connected therewith.

The network provider system **340** comprises a server which is located behind a firewall (not shown). The network provider system **340** provides access for the communications device **100,** through either the WAN **310,** the WLAN **320,** or one of the physical interfaces **330** to the devices connected, for example, through an enterprise network **350** (*e.g.* an intranet), to the network provider system **340,** such as a network **350,** an email server **355,** one or more application/content servers **360,** a second WAN **370** and/or an origin server **380.**

According to one embodiment, a mobile data delivery module **345** provides HTTP connectivity between the wireless WAN **310** and the WLAN **320** and the other physical connections **330** and devices and/or networks connected directly or indirectly to the network provider system **340.** In one embodiment, the mobile data delivery module **345** is implemented on a computer, such as one housing the network provider system **340.** The network **350,** the email server **355,** the application/content server **360,** the WAN **370** and the origin server **380** are individually and/or collectively in various combinations, a content source for the network provider system **340.** It will be appreciated that the system shown in **Figure 3** comprises one possible communications network or configuration for use with the mobile communication device **100.**

The network **350** may comprise a local area network, an intranet, the Internet, a direct connection, or combinations thereof. According to one embodiment, the network **350** comprises an intranet for a corporation or other type of organization.

In one example configuration, the email server **355** is connected to the network **350.** This server **355** is configured to direct or redirect email messages received over the WAN **370** and internally within the enterprise network **350** to be addressed to the mobile electronic device **100.**

The application/content server **360** may be connected to the network **350** and also to another network, for example, the second WAN **370.**

The second WAN **370** may further connect to other networks. In one embodiment, the second WAN **370** comprises or is configured with the Internet, a direct connection, a LAN, a wireless communication link, or any combination thereof.

Content providers, such as the origin server **380,** or Web servers, may be connected to the WAN **370.**

**The Global Positioning System (GPS)**

The communications environment **300** may also include a network of geosynchronous Global Positioning System (GPS) satellites **390.** The concept of the Global Positioning System was originally proposed as a worldwide means of navigation for the US military. It originally consisted of a series of 24 satellites **390** in orbit at an altitude of about 11,000 - 12,000 miles above the earth's surface. As of September 2007, there are 31 actively broadcasting satellites in the GPS constellation. The additional satellites improve the precision of the GPS receiver calculations by providing redundant measurements.

This high orbit, which lies well above the earth's atmosphere, yields a very precise and stable orbit that may be very accurately measured by a ground station. The orbit of each satellite is monitored twice daily by each of five monitoring stations.

The position of each satellite **390** is known at any given time, including minor adjustments for gravitational effects of other planetary bodies, such as the sun and moon. Typically, this information is stored in an almanac within each GPS receiver subsystem **260,** subject to periodic adjustments through message signals transmitted by each of the satellites **390.**

Each satellite **390** makes a complete orbit every 12 hours. The original constellation was spread out in six orbital planes. Thus, at any given point in time, from any point on earth, at least four or five satellites **390** may lie above the horizon and thus remain in view. With the increased number of satellites, the constellation was changed to a non-uniform arrangement to improve reliability and availability of the system upon a multiple satellite failure, relative to the former uniform system.

Each satellite **390** continuously transmits high-frequency, low power radio signals comprising a coded message on two channels that contain timing information and data about the satellite's orbit. One of the channels, denoted L1, is unencrypted and accessible by the general public. It generally transmits at 1575.42 MHz. The other, denoted L2, is only for use by the U.S. military's special receivers. These signals are received by antenna **261,** amplified by amplifier **262** and forwarded to the GPS receiver **266.**

In either case, the signal consists of an identical coded pseudo-random timing signal generated using a common reference clock signal and a message signal that identifies the transmitting satellite **390** and from which its position may be precisely determined, in conjunction with the almanac.

Each GPS receiver, such as the one **266** implemented in the mobile device **100** and shown in **Figure 2,** makes use of the pseudo-random timing signal from typically at least four different satellites **390.** The signals from each of these satellites **390** are fully and precisely synchronized with each other and with a complementary signal generated by the receiver **266.**

The delay between the signal generated by the GPS receiver **266** and those received by it from the satellites **390** may be used to derive the exact distance between the corresponding satellite **390** and the receiver **266,** by multiplying the delay by the speed of light.

Thus, with each received signal, the position of the GPS receiver subsystem **260** is constrained to lie on the surface of an imaginary sphere having a diameter equal to the distance between the subsystem **260** and the transmitting satellite **390** and centered about the known position of the transmitting satellite **390.**

The position of the GPS receiver subsystem **260** may thus be obtained by trilateration. With data from only three satellites **390,** a geographic non-elevation two-dimensional fix may be obtained, while a three-dimensional fix including elevation may be obtained with data from a minimum of four satellites **390.** The most accurate positional fix will be obtained from satellites **390** widely distributed across the sky and in each case having an angular elevation of in excess of 20 degrees above the horizon.

In addition to a positional fix, accurate time of day and velocity information may be deduced from the signals transmitted by the satellites **390.**

Optimal reception is obtained when the GPS receiver subsystem **260** is situated outdoors and with good visibility to most of the sky. Significantly degraded performance may be obtained when the GPS receiver is situated indoors, underwater, in caves or in deep canyons where sky visibility may be severely restricted. Typically, clouds or bad weather do not degrade receiver performance.

Clearly, the performance and accuracy of the GPS system and receiver subsystem **260** is dependent upon the accurate synchronization of the coded timing signals transmitted by each satellite **390** and generated by the receiver subsystem **260.** Precision, accuracy and synchronicity of the timing information as between the satellites **390** is maintained through the use of several atomic reference clocks in the satellite **390,** which are used to generate and synchronize the reference clock signals used to encode the coded timing signals to a common reference clock frequency. However, this is generally not feasible for the GPS receiver subsystem **260.**

Rather, the GPS receiver subsystem **260** makes use of a fixed, free-running clock signal having a frequency that is close to the common reference clock signal frequency, to control its operation and to permit synchronization with the GPS satellites **390.**

Once it has received timing signals from 3 or 4 satellites **390,** the receiver subsystem **260** is able to calculate any error in its clock frequency or phase by assuming that the distance measurements to each satellite **390** are proportionately inaccurate and reset its clock signal to compensate for and eliminate such error by supplying an appropriate frequency offset.

This clock signal is conventionally generated by the GPS receiver **260** from a rough oscillator signal provided as an input to the GPS receiver **260.** Typically, the rough oscillator signal is generated by a dedicated temperature-corrected crystal oscillator (TCXO).

As can be seen from **Figure 4,** this has been dispensed with in the present application having regard to the fact that in the communications device **100,** there may be a plurality of communications receivers, depending upon its particular configuration, for example, a cellular radio receiver in the WAN communications module **221,** a WLAN receiver in the WLAN communications subsystem **222** and perhaps in the short-range communications subsystem **223.**

Those having ordinary skill in the relevant art will appreciate that by far the majority of such communications receivers rely on a clock oscillator signal to properly receive and decode incoming message data. As shown in **Figure 4,** the clock signal from any of such receivers may be appropriated with a concomitant economy in components, cost and circuit board real estate.

Such economy arises from the replacement of the components for a dedicated TCXO, including a clock oscillator circuit, a crystal and temperature compensation components, as well as tuning and/or biasing components, with an NCO **490,** which effectively amounts to a few gates and an adder. The cost of implementing an NCO is further reduced when it is recognized that conventional GPS receivers **266** typically already have an NCO for each channel and an additional NCO to strip the carrier from the signal being received from the GPS satellites. As a result, the addition of a further NCO **490** will not add materially to the chip size of the GPS receiver **266.** It has been estimated that the cost savings on a component only basis may approach $2.00 per device **100,** most of which is attributable to the cost of the crystal. Those having ordinary skill in this art will appreciate that the cost of a 3$^{rd}$ party GPS receiver **266** may approach the component cost of the crystal.

In addition to component cost considerations, the replacement of a clock oscillator circuit with an NCO **490** has other salutary benefits. Power consumption will be significantly reduced, always an important consideration for portable and/or handheld devices, with the elimination of a further oscillator circuit that may draw between 1.0 and 1.5 mA at 3 V Vcc on a continuous basis.

Additionally, startup latency may be reduced because the NCO **490** will generate a clock signal immediately (assuming that the VCTCXO **400** is already in operation).

Moreover, with the elimination of a further oscillator circuit, the problem of routing a further set of clock signals about the circuit board to minimize interference will be obviated. By locating the NCO **490** within the GPS receiver **266,** there is only one clock signal on the circuit board.

However, simply replacing the dedicated TCXO with an NCO circuit is complicated because of the significant likelihood of discontinuities in the clock signal as a result of synchronizing "kicks", such as from the AFC module **466** as discussed above. While such kicks are appropriate to force synchronization of the WAN communications subsystem **221** with the base station **311,** were the frequency of the GPS clock signal **491** being used by the GPS receiver to decode GPS messages from the GPS satellites **390** to be correspondingly adjusted, signal lock may be lost, forcing the GPS receiver **266** back into a lengthy acquisition mode (on the order of several minutes), which is undesirable.

However, the "kicks" to be issued by the AFC module **466** are determinate and known. Accordingly, it is possible to compensate for the discontinuity occasioned by such kicks to the voltage control input of the VCTCXO **400** by providing a commensurate but opposite adjustment to NCO **490** along signal line **468** to maintain a relatively constant frequency and phase continuous clock signal that may be used by the GPS receiver **266** to receive messages from a GPS satellite **390.**

A series of curves, formulae and/or tables may be developed to establish the control word value to be supplied to the NCO **490** in order to counteract a given voltage control adjustment to the VCTCXO **400,** using the relationship between the control word sent out as a kick along signal line **467** and the voltage generated by the DAC **469**, the relationship between the input control voltage of the VCTCXO **400** and the output frequency generated thereby and the relationship between the control word value to be supplied to the NCO **490** and the resulting output frequency.

The present disclosure can be implemented in digital electronic circuitry, or in computer hardware, firmware, software, or in combination thereof. Apparatus of the application can be implemented in a computer program product tangibly embodied in a machine-readable storage device for execution by a programmable processor; and methods actions can be performed by a programmable processor executing a program of instructions to perform functions of the application by operating on input data and generating output. The application can be implemented advantageously on a programmable system including at least one input device, and at least one output device. Each computer program can be implemented in a high-level procedural or object-oriented programming language, or in assembly or machine language, if desired; and in any case, the language can be a compiled or interpreted language.

Suitable processors include, by way of example, both general and specific microprocessors. Generally, a processor will receive instructions and data from a read-only memory and/or a random access memory. Generally, a computer will include one or more mass storage devices for storing data file; such devices include magnetic disks and cards, such as internal hard disks, and removable disks and cards; magneto-optical disks; and optical disks. Storage devices suitable for tangibly embodying computer program instructions and data include all forms of volatile and non-volatile memory, including by way of example semiconductor memory devices, such as EPROM, EEPROM, and flash memory devices; magnetic disks such as internal hard disks and removable disks; magneto-optical disks; CD-ROM and DVD-ROM disks; and buffer circuits such as latches and/or flip flops. Any of the foregoing can be supplemented by, or incorporated in ASICs (application-specific integrated circuits), FPGAs (field-programmable gate arrays) and/or DSPs (digital signal processors).

Examples of such types of computer are programmable processing systems contained in the microprocessor **210** and the GPS receiver **266** suitable for implementing or performing the apparatus or methods of the application. The system may comprise a processor, a random access memory, a hard drive controller, and/or an input/output controller, coupled by a processor bus.

It will be apparent to those having ordinary skill in this art that various modifications and variations may be made to the embodiments disclosed herein, consistent with the present application, without departing from the present disclosure.

While preferred embodiments are disclosed, this is not intended to be limiting. Rather, the general principles set forth herein are considered to be merely illustrative of the scope of the present disclosure and it is to be further understood that numerous changes covering alternatives, modifications and equivalents may be made without straying from the scope of the present disclosure, as defined by the appended claims.

Further, the foregoing description of one or more specific embodiments does not limit the implementation of the disclosure to any particular computer programming language, operating system, system architecture or device architecture. Moreover, although some embodiments may include mobile devices, not all embodiments are limited to mobile devices; rather, various embodiments may be implemented within a variety of communications devices or terminals, including handheld devices, mobile telephones, personal digital assistants (PDAs), personal computers, audio-visual terminals, televisions and other devices.

Moreover, all dimensions described herein are intended solely to be exemplary for purposes of illustrating certain embodiments and are not intended to limit the scope of the disclosure to any embodiments that may depart from such dimensions as may be specified.

Certain terms are used throughout to refer to particular components. As one skilled in the art will appreciate, manufacturers may refer to a component by different names. It is not intended to distinguish between components that differ in name but not in function.

The terms "including" and "comprising" are used in an open-ended fashion, and thus should be interpreted to mean "including, but not limited to". The terms "example" and "exemplary" are used simply to identify instances for illustrative purposes and should hot be interpreted as limiting the scope of the disclosure to the stated instances.

Also, the term "couple" in any form is intended to mean either a direct or indirect connection through other devices and connections.

Other embodiments consistent with the present disclosure will become apparent from consideration of the specification and the practice of the disclosure disclosed herein.

Accordingly, the specification and the embodiments disclosed therein are to be considered examples only, with a true scope of the disclosure being disclosed by the following claims.

**Claims**

**1.** A system for providing a clock signal to a navigation satellite receiver (266) in a device (100) comprising a heterodyning communications receiver (221,222), the system comprising:

> a voltage controlled oscillator (400) for generating an output clock signal (401) having a frequency suitable to heterodyne signals at the heterodyning communications receiver (221,222); and
> a numerically controlled oscillator (NCO) (490) for generating, from the output clock signal (401), an adjusted output clock signal (491) having a frequency suitable to heterodyne signals at the navigation satellite receiver (266), wherein the frequency of the output clock signal (401) is governed by a voltage signal (464) to the voltage controlled oscillator (400) received from the heterodyning communications receiver (221,222), the frequency of the adjusted output clock signal (491) being adjustable in a phase and frequency continuous manner so as to compensate for a change in an operating environment of the heterodyning communications receiver (221,222).

2. The system according to claim 1, wherein the frequency of the adjusted output clock signal (491) is governed by a control value (468) to the NCO (490) from the heterodyning communications receiver (221,222) so as to counteract the compensation for the change in the operating environment of the heterodyning communications receiver (221,222).

3. The system according to claim 2, wherein the control value (468) is modulus added on successive clock cycles of the output clock signal (401) to a previous phase value to reflect a phase that corresponds to the frequency of the adjusted output clock signal (491).

4. The system according to claim 2, wherein the control value (468) is supplied by an automatic frequency control (AFC) (466) module within the heterodyning communications receiver (221,222).

5. The system according to claim 1, wherein the voltage signal (464) is supplied by an automatic frequency control (AFC) (466) module within the heterodyning communications receiver (221,222).

6. The system according to claim 5, wherein the AFC module (466) generates a voltage control word (467) and provides it to a digital to analog converter (469) for conversion into the voltage signal (464).

7. The system according to claim 1, wherein the heterodyning communications receiver (221,222) is for communication with a station (311,321) and wherein the change in the operating environment of the heterodyning communications receiver (221,222) is a change in station.

8. The system according to claim 1, wherein the NCO (490) comprises:

   a. a control word register (501);
   b. a phase accumulator module (510,520) adapted to update a previous value thereof to a current value thereof by modulus adding a value contained in the control word register (501) thereto on successive cycles of the output clock signal (401) so as to reflect a phase that corresponds to the frequency of the adjusted output clock signal (491);
   c. a phase to amplitude converter (539) to convert each current value to a corresponding amplitude value; and
   d. a digital to analog converter (540) to generate an adjusted analog clock signal from the amplitude values for forwarding to the navigation satellite receiver (266).

9. The system according to claim 1, wherein the heterodyning communications receiver (221) is a wide area network (WAN) communications receiver.

10. The system according to claim 1, wherein the heterodyning communications receiver (222) is a wireless local area network (WLAN) communications receiver.

11. The system according to claim 1, wherein the NCO (490) is coupled to the navigation satellite receiver through a phase locked loop (PLL) (402).

12. The system according to claim 1, wherein the device (100) is a mobile device.

13. The system according to claim 1, wherein the voltage controlled oscillator (400) forms part of the heterodyning communications receiver (221,222).

14. A method for providing a clock signal to a navigation satellite receiver (266) in a device (100) comprising a heterodyning communications receiver (221,222) and a voltage controlled oscillator (400), the method comprising:

   a. the voltage controlled oscillator (400) generating an output clock signal (401) having a frequency suitable to heterodyne signals at the heterodyning communication receiver (221, 222) and based on a voltage signal (464) received from the heterodyning communications receiver (221,222); and
   b. a numerically controlled oscillator (NCO) (490) generating, from the output clock signal (401), an adjusted output clock signal (491) in a phase and frequency continuous manner having a frequency suitable to heterodyne signals at the navigation satellite receiver (266), so as to compensate for a change in an operating environment of the heterodyning communications receiver (221,222).

15. The method according to claim 14, wherein the NCO (490) generates the adjusted output clock signal (491) based on a control value (468) from the heterodyning communications receiver (221,222) so as to counteract the compensation for the change in the operating environment of the heterodyning communications receiver (221,222).

**Patentansprüche**

1. System zum Liefern eines Taktsignals an einen Navigationssatellitenempfänger (266) in einer einen heterodynen Kommunikationsempfänger (221, 222) enthaltenden Vorrichtung (100), mit:

   einem spannungsgesteuertem Oszillator (400) zum Erzeugen eines Ausgabetaktsignals (401), das eine Frequenz hat, die dazu geeignet ist,
   Signale am heterodynen Kommunikationsempfänger (221, 222) zu überlagern, und
   einen nummerisch gesteuerten Oszillator (Numerically Controlled Oscillator, NCO) (490) zum Erzeugen eines angepassten Ausgabetaktsignals (491) aus dem Ausgabetaktsignal (401), wobei das angepasste Ausgabetaktsignal eine Frequenz hat, die dazu geeignet ist, Signale am Navigationssatellitenempfänger (266) zu überlagern, wobei die Frequenz des Ausgabetaktsignals (401) von einem Spannungssignal (464) zum spannungsgesteuerten Oszillator (400) geregelt wird, das vom heterodynen Kommunikationsempfänger (221, 222) empfangen ist, wobei die Frequenz des angepassten Ausgabetaktsignals (491) phasen- und frequenzkontinuierlich angepasst werden kann, um eine Änderung in einer Betriebsumgebung des heterodynen Kommunikationsempfängers (221, 222) zu kompensieren.

2. System nach Anspruch 1, wobei die Frequenz des angepassten Ausgabetaktsignals (491) von einem Stellwert (468) vom heterodynen Kommunikationsempfänger (221,222) zum nummerisch gesteuerten Oszillator (490) geleitet wird, um so der Kompensation der Änderung in der Betriebsumgebung des heterodynen Kommunikationsempfängers (221, 222) entgegenzuwirken.

3. System nach Anspruch 2, wobei an aufeinanderfolgenden Taktzyklen des Ausgabetaktsignals (401) der Stellwert (468) zu einem vorhergehenden Phasenwert in Modulus-Form hinzugezählt ist, um eine Phase zu reflektieren, die der Frequenz des angepassten Ausgabetaktsignals (491) entspricht.

4. System nach Anspruch 2, wobei der Stellwert (468) von einem Modul für automatische Frequenzregelung (Automatic Frequency Control, AFC) (466) im heterodynen Kommunikationsempfänger (221, 222) geliefert ist.

5. System nach Anspruch 1, wobei das Spannungssignal (464) von einem Modul für automatische Frequenzregelung (Automatic Frequency Control, AFC) (466) im heterodynen Kommunikationsempfänger (221, 222) geliefert ist.

6. System nach Anspruch 5, wobei das AFC-Modul (466) ein Spannungssteuerwort (467) erzeugt und es zum Wandeln in das Spannungssignal (464) einem Digital-Analog-Wandler (469) zur Verfügung stellt.

7. System nach Anspruch 1, wobei der heterodyne Kommunikationsempfänger (221, 222) der Kommunikation mit einer Station (311, 321) dient und wobei die Änderung der Betriebsumgebung des heterodynen Kommunikationsempfängers (221, 222) eine Änderung der Station ist.

8. System nach Anspruch 1, wobei der nummerisch gesteuerte Oszillator (490) enthält:

   a. ein Steuerwortregister (501);
   b. ein Phasenakkumulatormodul (510, 520), das dazu ausgelegt ist, einen vorhergehenden Wert davon zu aktualisieren, indem ein im Steuerwortregister (501) beinhalteter Wert an aufeinanderfolgenden Zyklen des Ausgabetaktsignals (401) dazu in Modulus-Form hinzugezählt wird, um so eine Phase zu reflektieren, die der Frequenz des angepassten Ausgabetaktsignals (491) entspricht.
   c. einen Phasen-Amplituden-Wandler (539), um jeden Stromwert in einen entsprechenden Amplitudenwert zu wandeln, und
   d. einen Digital-Analog-Wandler (540), um zum Weiterleiten an den Navigationssatellitenempfänger (266) aus den Amplitudenwerten ein angepasstes analoges Taktsignal zu erzeugen.

9. System nach Anspruch 1, wobei der heterodyne Kommunikationsempfänger (221) ein Kommunikationsempfänger eines Weitverkehrsnetzes (Wide Area Network, WAN) ist.

**10.** System nach Anspruch 1, wobei der heterodyne Kommunikationsempfänger (222) ein Kommunikationsempfänger eines drahtlosen lokalen Netzwerks (Wireless Local Area Network, WLAN) ist.

**11.** System nach Anspruch 1, wobei der nummerisch gesteuerte Oszillator (490) durch eine Phasenregelschleife (Phase Locked Loop, PLL) (402) mit dem Navigationssatellitenempfänger gekoppelt ist.

**12.** System nach Anspruch 1, wobei System nach Anspruch 1, wobei die Vorrichtung (100) eine Mobilvorrichtung ist.

**13.** System nach Anspruch 1, wobei der spannungsgesteuerte Oszillator (400) zum heterodynen Kommunikationsempfänger (221, 222) gehört.

**14.** Verfahren zum Liefern eines Taktsignals an einen Navigationssatellitenempfänger (266) in einer einen heterodynen Kommunikationsempfänger (221, 222) und einen spannungsgesteuerten Oszillator (400) enthaltenden Vorrichtung (100), wobei in dem Verfahren

a. der spannungsgesteuerte Oszillator (400) ein Ausgabetaktsignal (401) erzeugt, das eine Frequenz hat, die dazu geeignet ist, Signale am heterodynen Kommunikationsempfänger (221, 222) zu überlagern, und
b. ein nummerisch gesteuerter Oszillator (Numerically Controlled Oscillator, NCO) (490) phasen- und frequenzkontinuierlich aus dem Ausgabetaktsignal (401) ein angepasstes Ausgabetaktsignal (491) erzeugt, das eine Frequenz hat, die dazu geeignet ist, Signale am Navigationssatellitenempfänger (266) zu überlagern, um eine Änderung in einer Betriebsumgebung des heterodynen Kommunikationsempfängers (221, 222) zu kompensieren.

**15.** Verfahren nach Anspruch 14, wobei der nummerisch gesteuerte Oszillator (490) das angepasste Ausgabetaktsignal (491) auf Grundlage eines Stellwertes (468) vom heterodynen Kommunikationsempfänger (221, 222) erzeugt, um der Kompensation auf die Änderung der Betriebsumgebung des heterodynen Kommunikationsempfängers (221, 222) entgegenzuwirken.

**Revendications**

**1.** Système destiné à fournir un signal d'horloge à un récepteur (266) de satellite de navigation dans un dispositif (100) comprenant un récepteur (221, 222) de communications hétérodyne, le système comprenant :

un oscillateur (400) commandé en tension pour générer un signal d'horloge (401) de sortie ayant une fréquence appropriée pour des signaux hétérodynes au niveau du récepteur (221, 222) de communications hétérodyne ; et
un oscillateur (NCO) (490) à commande numérique pour générer, à partir du signal d'horloge (401) de sortie, un signal d'horloge (491) de sortie ajusté ayant une fréquence appropriée pour des signaux hétérodynes au niveau du récepteur (266) de satellite de navigation, dans lequel la fréquence du signal d'horloge (401) de sortie est gouvernée par un signal (464) de tension à l'oscillateur (400) commandé en tension reçu du récepteur (221, 222) de communications hétérodyne, la fréquence du signal d'horloge (491) de sortie ajusté étant ajustable d'une manière continue en phase et en fréquence de façon à compenser un changement dans un environnement de fonctionnement du récepteur (221, 222) de communications hétérodyne.

**2.** Système selon la revendication 1, dans lequel la fréquence du signal d'horloge (491) de sortie ajusté est gouvernée par une valeur de commande (468) au NCO (490) provenant du récepteur (221, 222) de communications hétérodyne de manière à contrebalancer la compensation du changement dans l'environnement de fonctionnement du récepteur (221, 222) de communications hétérodyne.

**3.** Système selon la revendication 2, dans lequel la valeur de commande (468) est ajoutée en module à des cycles d'horloge successifs du signal d'horloge (401) de sortie à une valeur de phase précédente afin de refléter une phase qui correspond à la fréquence du signal d'horloge (491) de sortie ajusté.

**4.** Système selon la revendication 2, dans lequel la valeur de commande (468) est alimentée par un module (466) de commande automatique de fréquences (AFC) dans le récepteur (221, 222) de communications hétérodyne.

**5.** Système selon la revendication 1, dans lequel le signal de tension (464) est alimenté par un module (466) de commande automatique de fréquences (AFC) dans le récepteur (221, 222) de communications hétérodyne.

**6.** Système selon la revendication 5, dans lequel le module AFC (466) génère un mot de commande de tension (467) et le procure à un convertisseur numérique-analogique (469) pour le convertir en le signal de tension (464).

**7.** Système selon la revendication 1, dans lequel le récepteur (221, 222) de communications hétérodyne est destiné à communiquer avec une station (311, 321) et dans lequel le changement dans l'environnement de fonctionnement du récepteur (221, 222) de communications hétérodyne est un changement de station.

**8.** Système selon la revendication 1, dans lequel le NCO (490) comprend :

a. un registre (501) de mots de commande ;
b. un module (510, 520) accumulateur de phases adapté pour mettre à jour une valeur précédente correspondante en une valeur de courant correspondante en lui ajoutant en module une valeur contenue dans le registre (501) de mots de commande à des cycles successifs du signal d'horloge (401) de sortie de manière à refléter une phase qui correspond à la fréquence du signal d'horloge (491) de sortie ajusté ;
c. un convertisseur (539) phase-amplitude pour convertir chaque valeur de courant en une valeur d'amplitude correspondante ; et
d. un convertisseur numérique-analogique (540) pour générer un signal d'horloge analogique ajusté à partir des valeurs d'amplitudes à renvoyer au récepteur (266) de satellite de navigation.

**9.** Système selon la revendication 1, dans lequel le récepteur (221) de communications hétérodyne est un récepteur de communications d'un réseau étendu (WAN).

**10.** Système selon la revendication 1, dans lequel le récepteur (225) de communications hétérodyne est un récepteur de communications d'un réseau local (WLAN) sans fil.

**11.** Système selon la revendication 1, dans lequel le NCO (490) est couplé au récepteur de satellite de navigation à travers une boucle à verrouillage de phase (PLL) (402).

**12.** Système selon la revendication 1, dans lequel le dispositif (100) est un dispositif mobile.

**13.** Système selon la revendication 1, dans lequel l'oscillateur (400) commandé en tension constitue une partie du récepteur (221, 222) de communications hétérodyne.

**14.** Procédé destiné à pourvoir un signal d'horloge à un récepteur (266) de satellite de navigation dans un dispositif (100) comprenant un récepteur (221, 222) de communications hétérodyne et un oscillateur (400) commandé en tension, le procédé comprenant le fait que :

a. l'oscillateur (400) commandé en tension génère un signal d'horloge (401) de sortie ayant une fréquence appropriée pour des signaux hétérodynes au niveau du récepteur (221, 222) de communications hétérodyne et sur la base d'un signal de tension (464) reçu du récepteur (221, 222) de communications hétérodyne ; et
b. un oscillateur (NCO) (490) à commande numérique génère, à partir du signal d'horloge (401) de sortie, un signal d'horloge (491) de sortie ajusté d'une manière continue en phase et en fréquence ayant une fréquence appropriée pour des signaux hétérodynes au niveau du récepteur (266) de satellite de navigation, de manière à compenser un changement dans un environnement de fonctionnement du récepteur (221, 222) de communications hétérodyne.

**15.** Procédé selon la revendication 14, dans lequel le NCO (490) génère le signal d'horloge (491) de sortie ajusté sur la base d'une valeur de commande (468) provenant du récepteur (221, 222) de communications hétérodyne de manière à contrebalancer la compensation du changement dans l'environnement de fonctionnement du récepteur (221, 222) de communications hétérodyne.

**FIG. 1**

**FIG. 2**

FIG. 3

FIG. 4

FIG. 5

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 1707978 A
- US 6064336 A, Krasner
- US 2001002831 A1, Krasner